(19) Europäisches Patentamt
European Patent Office
Office européen des brevets

(11) **EP 4 485 801 B1**

(12) **EUROPEAN PATENT SPECIFICATION**

(45) Date of publication and mention
of the grant of the patent:
**13.05.2026 Bulletin 2026/20**

(21) Application number: **24182741.9**

(22) Date of filing: **18.06.2024**

(51) International Patent Classification (IPC):
***H03K 17/14*** *(2006.01)* ***H03K 17/16*** *(2006.01)*

(52) Cooperative Patent Classification (CPC):
**H03K 17/168; H03K 17/14; H03K 2017/0806**

(54) **ADAPTIVE GATE DRIVER WITH NEGATIVE TEMPERATURE COEFFICIENT (NTC) RESISTOR**

ADAPTIVER GATE-TREIBER MIT WIDERSTAND GEGEN NEGATIVE TEMPERATURKOEFFIZIENTEN (NTC)

CIRCUIT D'ATTAQUE DE GRILLE ADAPTATIF AVEC RÉSISTANCE À COEFFICIENT DE TEMPÉRATURE NÉGATIF (NTC)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.06.2023 IN 202311043329**
**11.06.2024 US 202418740124**

(43) Date of publication of application:
**01.01.2025 Bulletin 2025/01**

(73) Proprietor: **Vertiv Corporation**
**Westerville, OH 43082 (US)**

(72) Inventor: **Raut, Dilesh Arvind**
**410507 Pune (IN)**

(74) Representative: **Cousens, Nico et al**
**Kilburn & Strode LLP**
**Lacon London**
**84 Theobalds Road**
**London WC1X 8NL (GB)**

(56) References cited:
**CN-A- 107 171 659     CN-A- 115 250 065**
**DE-A1- 102010 043 109     KR-A- 20180 070 414**
**US-A1- 2020 021 102     US-B2- 11 949 406**
**US-B2- 9 041 437**

## Description

### CROSS-REFERENCE TO RELATED APPLICATIONS

The present application claims the benefit under 35 U.S.C. § 119(e) of Indian Provisional Patent Application Serial Number 202311043329 filed June 28, 2023.

### TECHNICAL FIELD

The present disclosure is directed generally to the field of integrated circuitry and particularly to an adaptive gate drive circuit for a semiconductor switching device.

### BACKGROUND

Power inverters for semiconductor devices may convert direct current (DC) into, e.g., three-phase alternating current (AC) and provide the alternating current as a gate drive voltage, switching rapidly between on (e.g., positive voltage) and off (e.g., non-positive voltage, or zero/negative voltage) states controlled by semiconductor switches (e.g., metal oxide semiconductor field effect transistor, MOSFET, or insulated gate bipolar transistor, IGBT). Gate resistors determine how rapidly the semiconductor switches between on and off states. Generally, the faster the switching, the lower the power loss associated with the switching. However, the faster the semiconductor switches switch, the greater the radiation emitted by the semiconductor switches. Comité International Spécial des Perturbations Radioélectriques (CISPR) or equivalent standards provide for maximum allowable radiation levels. Accordingly, gate resistors may be chosen to moderate power losses and enforce radiated emission limits. However, as more current flows through the semiconductor switches, junction temperatures will increase. If gate resistance increases, turn-on switching losses will increase linearly. However, if gate resistance is kept constant, switching delays and switching losses will both increase as junction temperatures rise.

US 2020/021102 A1 in its abstract states "The present invention relates to a power converting device, and more particularly, to a power converting device capable of protecting a compressor from overheat, a compressor including the same, and a control method thereof. The device includes an inverter for generating an alternate current for driving the motor using power supplied from a power supply, the inverter including a plurality of switching elements; a driver for driving the plurality of switching elements; a variable resistance unit disposed between and electrically coupled to the driver and a gate of each of the switching elements, wherein the variable resistance unit has a resistance value inversely proportional to a temperature of the inverter; and a controller configured for transferring a drive signal to the driver."

CN 107 171 659 A in its abstract states "The invention discloses a semiconductor switch device and an electric power converter. The semiconductor switch device comprises a semiconductor switch, a driving circuit for controlling the turn-on or turn-off of the semiconductor switch, and a variable resistor connected between the output end of the driving circuit and the semiconductor switch, wherein the resistance value of the variable resistor is negatively related to the temperature and capable of measuring the temperature of the semiconductor switch; two same semiconductor switch devices are serially connected in a power supply loop of a controlled circuit as the electric power converter to control the on and off of the controlled circuit; when the temperatures of the semiconductor switches in two semiconductor switch devices are different due to different switch losses, the variable resistor in each of two semiconductor switch devices can adjust the own resistance value according to the characteristic that the resistance value thereof is negatively related to the temperature, the switch loss difference of the semiconductor switches in two semiconductor switch devices is reduced, thereby indirectly reducing the temperature difference of the semiconductor switches in two semiconductor switch devices; the balance of each of the voltage, the switch loss and the temperature between two semiconductor switch devices is realized." (machine translation)

DE 10 2010 043109 A1 in its abstract states "The circuit device (2) has a negative temperature coefficient (NTC) resistor (10) that is coupled with a MOSFET (4), through a coupling portion (14). The MOSFET is actuated by pulse width modulation (PWM) signal (8). The NTC resistor is established to influence the rising and falling edges of the PWM signal. An independent claim is included for method for operation of MOSFET using pulse width modulated signal." (machine translation)

### SUMMARY

In a first aspect, an adaptive gate drive circuit according to independent claim 1 is disclosed.

In a further aspect, a method for optimal switching of a semiconductor switch according to independent claim 6 is disclosed.

Further preferred embodiments are defined in the dependent claims.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:

FIG. 1 is a block diagram of a conventional gate drive circuit for a semiconductor device;

FIGS. 2A and 2B are graphical representations of increased switching losses as current and gate resistance increases through the conventional gate drive circuit of FIG. 1;

FIG. 3 is a tabular representation of increased switching losses and switching timings as junction temperature increases across semiconductor switches of the conventional gate drive circuit of FIG. 1;

FIG. 4 is a block diagram illustrating a gate drive circuit incorporating a negative temperature coefficient (NTC) gate resistance device according to example embodiments of this disclosure;

FIG. 5A is a graphical illustration of gate resistance of the individual components of the NTC gate resistance device of FIG. 4 as a function of temperature;

FIG. 5B is a graphical illustration of the collective gate resistance of the NTC gate resistance device of FIG 4 as a function of temperature;

FIG. 6 is a graphical illustration of, respectively, turn-on and turn-off switching timings of the conventional gate drive circuit of FIG. 1 at a nominal junction temperature; turn-on and turn-off switching timings of the conventional gate drive circuit of FIG. 1 at an elevated junction temperature; and turn-on and turn-off switching timings of the gate drive circuit of FIG. 4 at the elevated junction temperature, according to example embodiments of this disclosure;

and FIGS. 7A through 7C are process flow diagrams illustrating a method for optimal switching of a semiconductor device according to example embodiments of this disclosure.

DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.
As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.
Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).
In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.
Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to a system and method for operating a semiconductor device at optimal efficiency via an adaptive gate drive circuit incorporating negative temperature coefficient (NTC) gate resistors ("thermistors"). For example, in conventional gate drive circuits an NTC gate resistor or thermistor (e.g., the resistance of which may decrease as temperature increases) may infer a junction temperature of a semiconductor switch (e.g., metal oxide semiconductor field effect transistors, MOSFET, insulated gate bridge transistors, IGBT, other like transistors or switching devices) based on a sensed temperature of a heatsink or base plate (which itself may be based on heat transferred from the semiconductor switch, and therefore may be associated with a finite delay). Circuit controllers may then lower voltage, current, and/or switching frequency in response to rising junction temperatures. However, adaptive gate drive circuits according to example embodiments of the inventive concepts disclosed herein may place NTC gate resistors closer to the actual junctions of the semiconductor switches, eliminating the need to regularly monitor heatsink temperature and the associated delay. The semiconductor switches are able to perform faster on/off switching while reducing switching losses and preserving radiated emissions limits at higher junction temperatures. The thermal time constant of the system may be increased, and intelligence transferred from microprocessor-based controllers to the gate drive circuit.

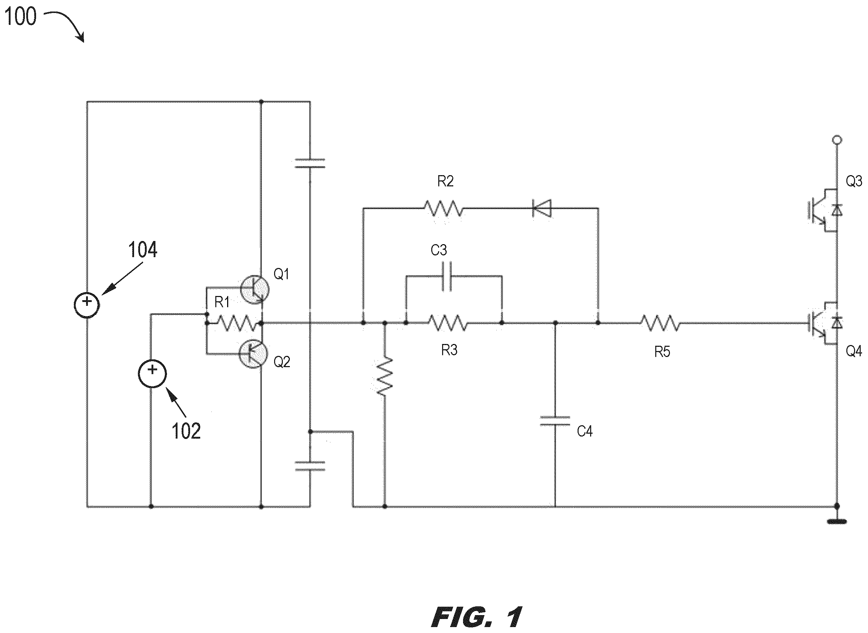

Referring now to FIG. 1, a conventional gate drive circuit 100 for a semiconductor device is shown. On/off control signals 102 (e.g., associated respectively with positive or non-positive (e.g., zero or negative) gate drive voltages 104 (e.g., $V_{CE} = 600$ V, $V_{CE} = \pm 15$ V) are amplified by the totem pole circuit of transistors Q1, Q2 and resistor R1. Transistors (e.g., semiconductor switches) Q3, Q4 form one arm of a three-phase half-bridge inverter and control on/off switching based on the control signals. In embodiments, transistors Q3 and Q4 are insulated gate bridge transistors, IGBT. Resistors R3, R5 and capacitors C3, C4 form a circuit for providing current when, Q4 is in a turn-on/ON state; additionally, when Q4 is in a turn-off/OFF state resistor R2 is connected in parallel with R3 (e.g., along with C4, R5). When turning on, Q4 can be switched slower or faster by varying the resistance of R3, R5 and the capacitance of C4.

In embodiments, turn-on and turn-off switching timings (e.g., for ON and OFF states respectively) each have three primary components. For example, turn-on switching timing may include a rise time $t_r$, a switching delay $t_{d(on)}$, and a charge time (e.g., for charging gate capacitors C3, C4). Similarly, turn-off switching timing may include a fall time $t_f$, a switching delay $t_{d(off)}$, and a discharge time (e.g., for discharging gate capacitance from C4). Ideally Q4 should switch on/off as rapidly as possible in order to reduce power losses associated with switching. With respect to Q4, power loss includes switching loss and conduction loss:

$$Pav = \frac{1}{T} \int_0^T P(t)dt$$

$$= F\left[\sum_{n_{on}} E_{on}\left(I_{n_{on}}, V_{n_{on}}\right) + \sum_{n_{off}} E_{off}\left(I_{n_{off}}, V_{n_{off}}\right) + \right] + \sum_{T_{cond_n}} \frac{1}{T} \int_{T_{cond_n}} P(t)dt$$

However, as Q4 is switched faster, emissions radiated by the semiconductor switches increase. As noted above, CISPR or equivalent standards provide for upper bounds on acceptable levels of radiated emissions. Accordingly, the selection of gate resistors R5 may be an engineering compromise to moderate power losses and preserve radiated emissions limits.

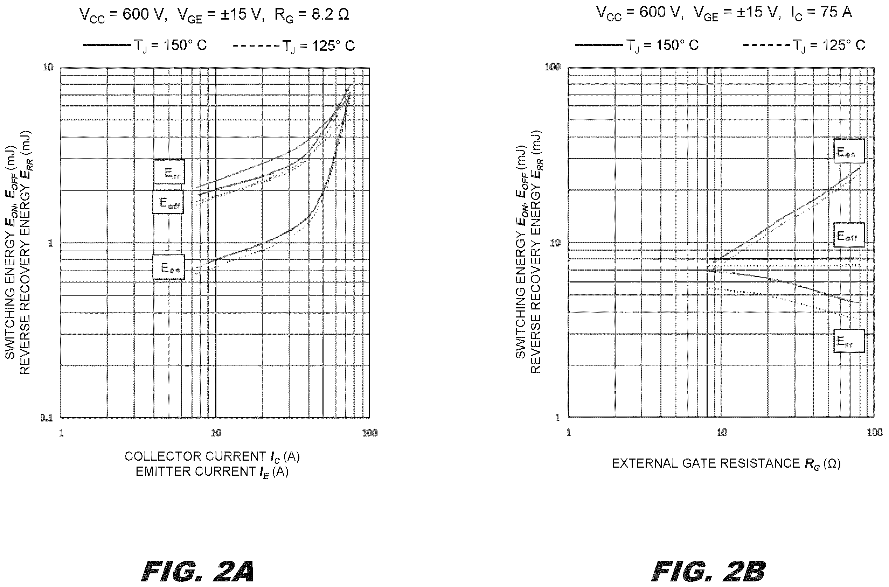

Referring to FIGS. 2A and 2B, switching loss characteristics of a typical half-bridge semiconductor switch (e.g., Q3, Q4 in FIG. 1) is shown. For example, as shown by FIG. 2A, turn-on switching losses $E_{on}$ and turn-off switching losses $E_{off}$ (in millijoules) are generally a function of current flowing through the semiconductor switch (e.g., collector current $Ic$, emitter current $I_E$) when the gate resistance $R_G$ of gate resistor R5 is kept constant, increasing uniformly as the junction temperature $T_j$ across the semiconductor switch Q3, Q4 rises from 125° C to 150° C.

As shown by FIG. 2B, as gate resistance $R_G$ (e.g., internal or external) increases, turn-on switching losses $E_{on}$ increase linearly.

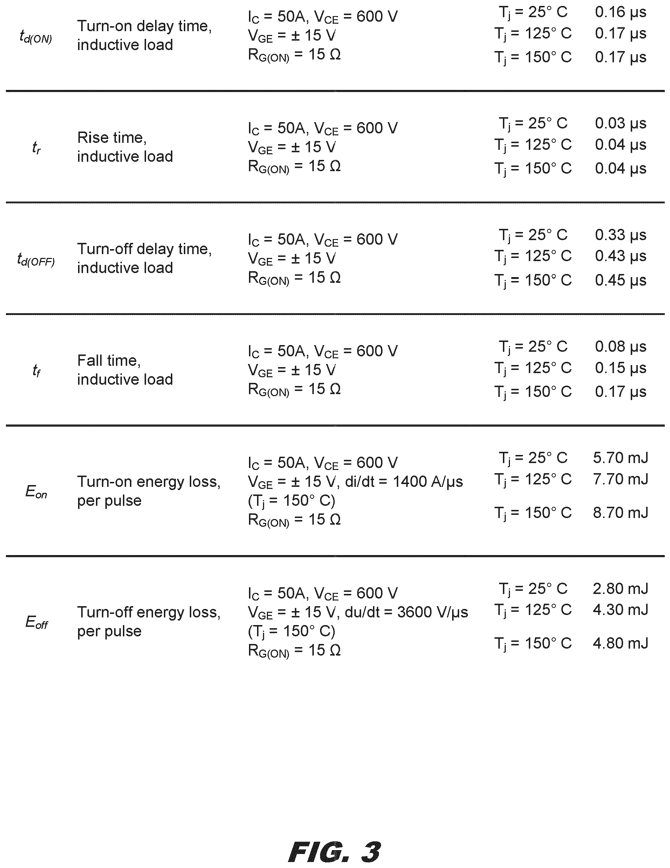

Referring also to FIG. 3, switching timing components of the typical half-bridge semiconductor switch (Q3, Q4, FIG. 2) are shown. For example, as collector current load $Ic$, gate drive voltage $V_{CE}$, $V_{GE}$, and gate resistance $R_{G(on)}$, $R_{G(off)}$ remain constant and junction temperature $T_j$ increases from a nominal 25° C to 125° C and 150° C, switching delays $t_{d(on)}$, $t_{d(off)}$ increase with temperature, as do rise and fall times $t_r$, $t_f$. Similarly, as noted above with respect to FIG. 2B,

switching losses $E_{on}$, $E_{off}$ likewise increase with temperature.

As shown by FIG. 2B above, turn-on switching loss $E_{on}$ increases in roughly direct proportionality to an increase in gate resistance $R_{G(on)}$, which may cause junction temperatures $T_j$ to rise, which in turn may increase switching timing delays, slowing operations of the semiconductor device. Further, junction temperatures $T_j$ may rise sufficiently as to cause a failure in the gate drive circuit 100.

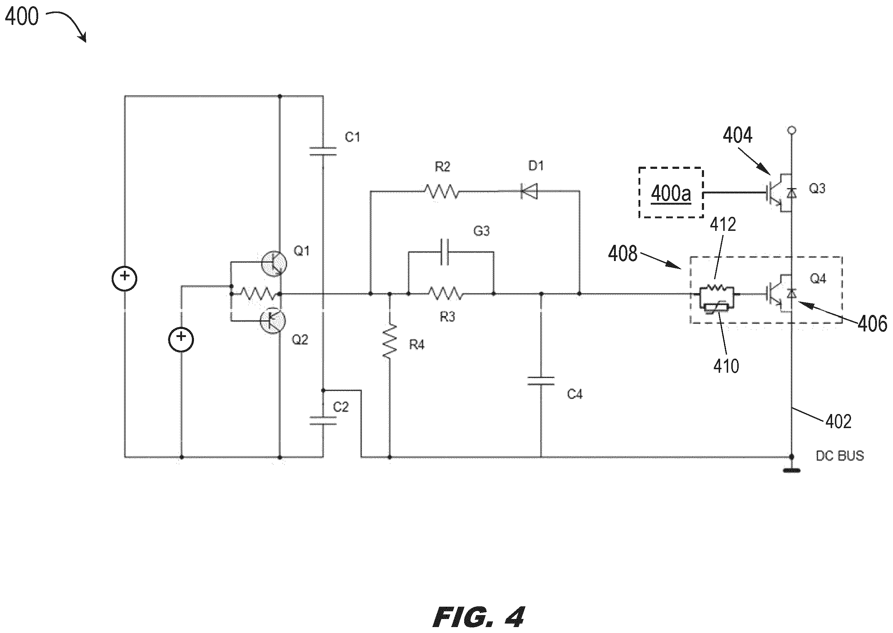

Referring now to FIG. 4, the adaptive gate drive circuit 400 is shown. The adaptive gate drive circuit 400 may supply power to a connected semiconductor device (not shown) via a DC bus 402, controlled by semiconductor switches 404, 406 (e.g., IGBTs Q3 and Q4 respectively).

Broadly speaking, the adaptive gate drive circuit 400 allows the connected semiconductor switch Q4 (406) to operate more efficiently, and switch more rapidly, while moderating switching losses and maintaining both junction temperatures and radiated emissions at acceptable levels. In embodiments, the properties attributed to the Q4 IGBT 406 may similarly apply to the Q3 IGBT 404, which may have its own dedicated adaptive gate drive circuit 400a that may be implemented and may function similarly to the adaptive gate drive circuit 400 dedicated to the Q4 IGBT. For example, all references below to the adaptive gate drive circuit 400, to components thereof, and to the semiconductor switch 406 (e.g., IGBT Q4) may similarly apply to the adaptive gate drive circuit 400a and semiconductor switch 404 (e.g., IGBT Q3).

In embodiments, the adaptive gate drive circuit 400 may incorporate a gate resistance device 408 disposed proximate to the semiconductor switch 406. For example, the gate resistance device 408 may include a negative temperature coefficient, NTC, thermistor 410 configured to monitor the junction temperature of the semiconductor switch 406, the NTC thermistor connected in parallel with a linear gate resistor 412. In some embodiments, the gate resistance device 408 may be disposed proximate to the semiconductor device (not shown) to monitor a chip temperature thereof. In some embodiments, the semiconductor device and/or the adaptive gate drive circuit 400 are system-on-chip, SoC, devices or surface-mounted devices, SMD. For example, placing the gate resistance device 408 proximate to the semiconductor switch 406 and/or semiconductor device allows proper temperature coupling of the NTC thermistor 410 and allows the gate resistance device to adjust gate resistance in response to changes in junction temperature (e.g., chip temperature) with minimal delay.

In embodiments, the NTC thermistor 410 and gate resistor 412 are configured for adjustable resistance based on junction temperatures sensed by the NTC thermistor. For example, as current flowing through the semiconductor switch 406 increases (e.g., collector current $I_C$, emitter current $I_E$), increasing switching losses and therefore increasing junction temperature, the gate resistance device 408 may decrease gate resistance. The decreased gate resistance allows the semiconductor switch 406 to switch faster (e.g., reduced switching delay).

In embodiments, if current load through the semiconductor switch 406 is reduced, conduction losses may likewise decrease and the junction temperature may fall. Accordingly, the gate resistance device 408 may respond to the lower junction temperature by increasing gate resistance to operate the semiconductor switch 406 at normal switching loss levels. Broadly speaking, optimizing the semiconductor switch 406 and its cooling system allows the thermal time constant of the semiconductor switch and cooling system to significantly increase.

In embodiments, the gate resistance $R_{G(on)}$, $R_{G(off)}$ of the gate resistance device 408 may be adjusted between minimum and maximum resistance levels. For example, the minimum resistance may be determined by maximum acceptable radiated emissions levels at turn-on and turn-off. Similarly, maximum resistance levels may be determined based on the thermal or power capacity of the semiconductor switch 406 (e.g., and any available cooling systems or heatsinks).

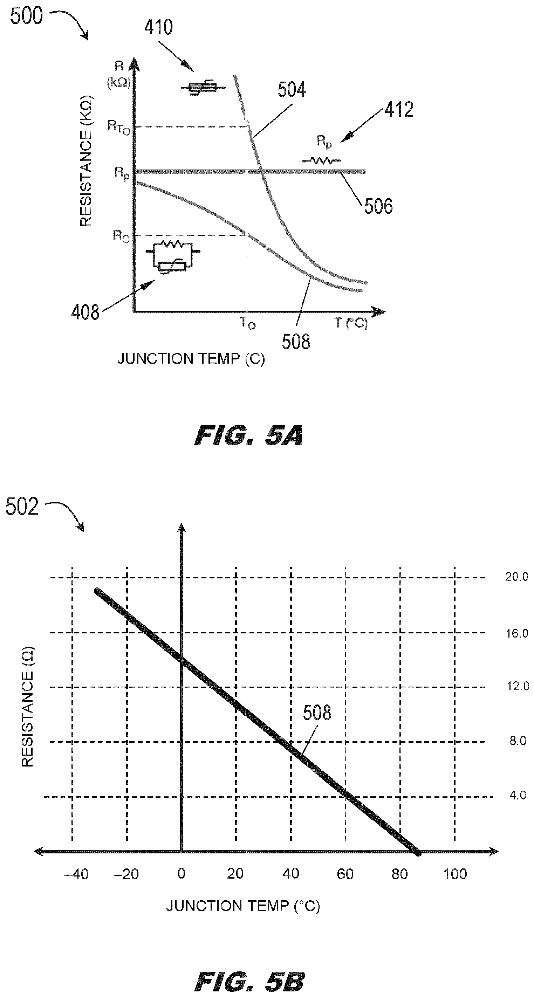

In embodiments, referring also to FIGS. 5A and 5B, the graphs 500, 502 illustrate resistance (R; kΩ (500), Ω (504)) of the individual components of the gate resistance device 408 of the adaptive gate drive circuit 400, 400a (FIG. 4; e.g., the NTC thermistor 410, gate resistor 412) as a function of junction temperature (°C), as opposed to the resistance of the composite gate resistance device (e.g., wherein the NTC thermistor and gate resistor are connected in parallel) as a whole.

The gate resistance device 408 includes the gate resistor 412 connected in parallel with the NTC thermistor 410 to ensure the gate resistance device is configured to reduce overall gate resistance in inverse linear proportion to an increase in junction temperature. For example, the resistance curve 504 of the NTC thermistor 410 as a function of junction temperature may be generally inverse, but non-linear, in nature. However, by connecting the NTC thermistor 410 in parallel with a gate resistor 412 having a linear resistance curve 506, the resistance curve 508 of the composite gate resistance device 408 may closely approximate an inverse linear relationship to junction temperature (as best shown by FIG. 5B).

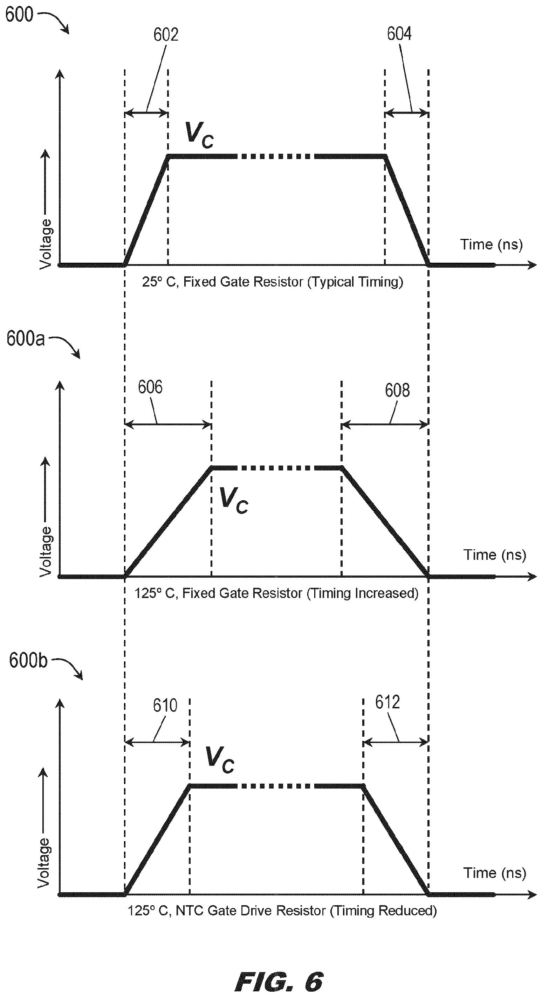

Referring now to FIG. 6, the graph 600 illustrates typical turn-on switching timings 602 and turn-off switching timings 604 for the conventional semiconductor switch, IGBT (Q4, FIG. 1). In embodiments, turn-on and turn-off switching timings 602, 604 at a nominal 25° C junction temperature are represented in terms of the collector voltage, Vc, of the semiconductor switch 404, 406 as a function of time (e.g., in nanoseconds (ns)). As noted above, turn-on switching timings 602 include a rise time $t_r$, a switching delay $t_{d(on)}$, and a charge time (e.g., for charging internal/external gate capacitors). Similarly, turn-off switching timings 604 includes a fall time $t_f$, a switching delay $t_{d(off)}$, and a discharge time.

The graph 600a illustrates typical turn-on and turn-off switching timings 606, 608 for the conventional semiconductor switch Q4 at an elevated junction temperature of 125° C. As noted above, longer turn-on and turn-off switching timings 606, 608 (due to one or more of, e.g., longer rise/fall times, longer switching delays, longer charge/discharge times) increase switching losses, which in turn increases junction and chip temperatures, which may in turn lead to thermal runaway conditions.

The graph 600b illustrates turn-off and turn-on switching timings 610, 612 for the semiconductor switch Q3, Q4 (404, 406; FIG. 4) and adaptive gate drive circuit (400, 400a; FIG. 4) at the elevated junction temperature of 125° C. In embodiments, the incorporation of the gate resistance device 408 by the adaptive gate drive circuit 400, 400a may reduce switching delays as well as charge/discharge times, reducing overall switching losses even at elevated junction temperatures while maintaining radiated emissions from the semiconductor switches 404. 406 within acceptable limits.

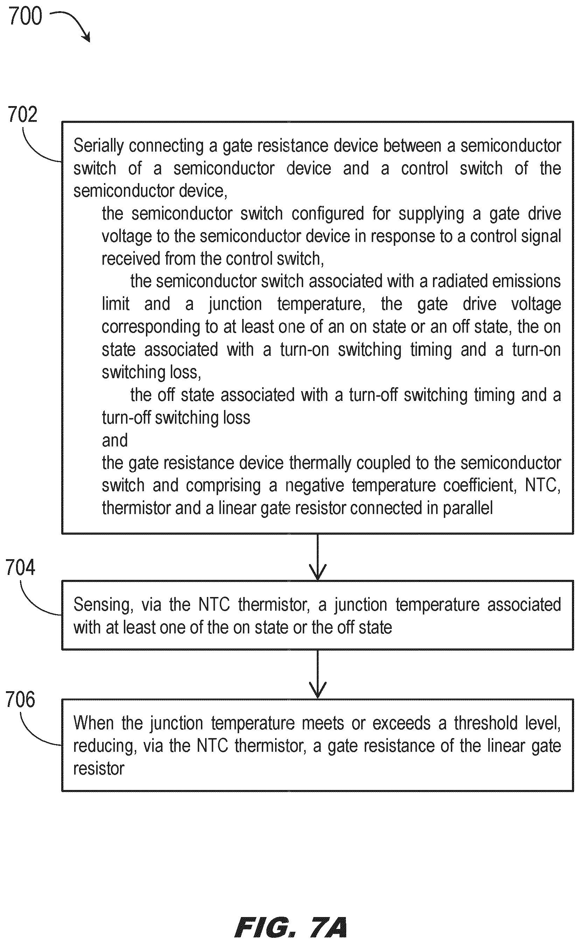

Referring now to FIG. 7A, the method of operation 700 may be implemented by the adaptive gate drive circuits 400, 400a and includes the following steps.

At a step 702, a gate resistance device is serially connected between each semiconductor switch (e.g., an insulated gate bipolar transistor, IGBT) of a semiconductor device and the control switch of the semiconductor device. For example, each gate resistance device includes a negative temperature coefficient, NTC, thermistor (placed close to the IGBT junction) and a linear gate resistor connected in parallel. In embodiments, the semiconductor switch supplies a gate drive voltage to the semiconductor device (e.g., in response to a control signal received from the control switch). Further, the semiconductor switch is associated with a radiation emission limit (corresponding to a minimum gate resistance of the linear gate resistor), a junction temperature, and/or a power capacity (corresponding to a maximum gate resistance of the linear gate resistor). Further still, the gate drive voltage corresponds to one of an ON state (e.g., associated with a turn-on switching timing and a turn-on switching loss) or an OFF state (e.g., associated with a turn-off switching timing and a turn-on switching loss). For example, the turn-on switching timing may include a turn-on delay, a rise time, and/or a charging time associated with the ON state. Similarly, the turn-off switching timing includes a turn-off delay, a fall time, and/or a discharging time associated with the OFF state. In some embodiments, the semiconductor device is a system-on-a-chip (SoC), and one or more of the semiconductor switch or the gate resistance device is a surface mounted device.

At a step 704, the NTC thermistor senses the junction temperature associated with switching operations of the semiconductor switch (e.g., ON/OFF switching).

At a step 706, when the junction temperature meets or exceeds a threshold temperature, the NTC reduces the gate resistance of the linear resistor. In some embodiments, the NTC reduces gate resistance until the junction temperature falls back below the threshold level, allowing rapid ON/OFF switching by the semiconductor switch with minimal delay and/or minimal conduction loss. In some embodiments, the NTC thermistor reduces the gate resistance of the linear gate resistor based on an inverse linear relationship with an increase in a sensed junction temperature.

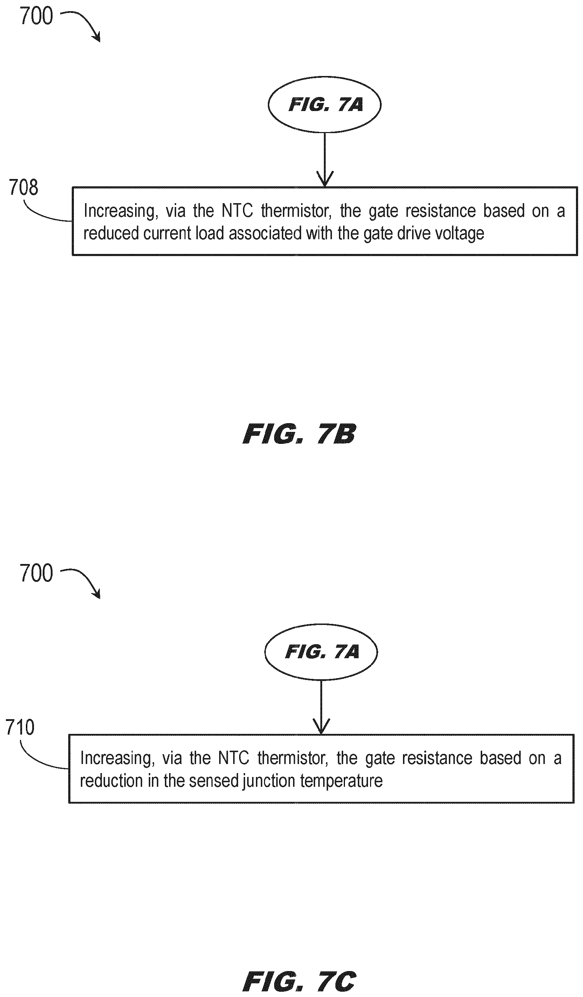

Referring also to FIG. 7B, the method 700 may include an additional step 708. At the step 708, the NTC thermistor responds to the fall in junction temperature by increasing the gate resistance of the linear gate resistor to allow the semiconductor switch to continue operating at normal switching loss levels.

Referring also to FIG. 7C, the method 700 may include an additional step 710. At the step 710, the NTC thermistor responds to a reduction in the current load based on the gate drive voltage by increasing the gate resistance of the linear gate resistor.

CONCLUSION

It is contemplated that the system may have numerous advantages. For example, the system may provide the end user with the ability to customize the user interface, as well as a final view of the user interface incorporating the desired data, in near real time. Similarly, the system will significantly reduce cycle time in incorporating and finalizing end user requirements and desired features.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein. Furthermore, it is to be understood that the invention is defined by the appended claims.

**Claims**

1. A gate drive circuit (400), comprising:

   at least one semiconductor switch (406, Q4) configured to supply power in response to a control signal received from a control switch (Q1, Q2), the at least one semiconductor switch (406, Q4) associated with:

   a radiated emissions limit; and
   a junction temperature;

   wherein a gate drive voltage of the at least one semiconductor switch (406, Q4) is one of:

   a positive voltage corresponding to an on state, the on state associated with at least one of a turn-on switching timing or a turn-on switching loss; and
   a non-positive voltage corresponding to an off state, the off state associated with at least one of a turn-off switching timing or a turn-off switching loss; and

   a gate resistance device (408) serially connected between the control switch (Q1, Q2) and the at least one semiconductor switch (406, Q4), the gate resistance device thermally coupled to the at least one semiconductor switch (406, Q4), the gate resistance device comprising a negative temperature coefficient "NTC" thermistor (410) and a gate resistor (412) connected in parallel;
   wherein the NTC thermistor (410) is configured to:

   sense a junction temperature associated with at least one of the on state or the off state; and
   in response to a change in the junction temperature, adjust one or more of the associated turn-on or turn-off switching timing or the associated turn-on or turn-off switching loss by adjusting a gate resistance of the gate resistance device,
   **characterised in that** the NTC thermistor is configured to reduce the gate resistance based on an inverse linear relationship with an increase in the sensed junction temperature.

2. The gate drive circuit of any preceding claim, wherein the NTC thermistor is configured to increase the gate resistance based on a reduced current load associated with the gate drive voltage.

3. The gate drive circuit of any preceding claim, wherein the NTC thermistor is configured to increase the gate resistance based on a reduction in the sensed junction temperature.

4. The gate drive circuit of any preceding claim, wherein the gate resistor is associated with:

   a minimum gate resistance corresponding to the radiated emissions limit; and
   a maximum gate resistance based on a power capacity of the semiconductor switch.

5. The gate drive circuit of any preceding claim, wherein the at least one semiconductor switch includes at least one insulated gate bipolar transistor "IGBT".

6. A method for optimal switching of a semiconductor switch, the method comprising:

   serially connecting a gate resistance device between the semiconductor switch and a control switch of the semiconductor switch,

   the control switch configured for supplying a gate drive voltage to the semiconductor switch, the semiconductor switch associated with a radiated emissions limit and a junction temperature, the gate drive voltage corresponding to at least one of an on state or an off state, the on state associated with a turn-on switching timing and a turn-on switching loss, the off state associated with a turn-off switching timing and a turn-off switching loss; and

the gate resistance device thermally coupled to the semiconductor switch and comprising a negative temperature coefficient "NTC" thermistor and a gate resistor connected in parallel;

sensing, via the NTC thermistor, a junction temperature associated with at least one of the on state or the off state; and

in response to a change in the junction temperature adjusting one or more of the associated turn-on or turn-off switching timing or the associated turn-on or turn-off switching loss by adjusting , via the NTC thermistor, a gate resistance of the gate resistance device,

**characterised in that** reducing, via the NTC thermistor, a gate resistance of the gate resistance device, includes: reducing the gate resistance based on an inverse linear relationship with an increase in the sensed junction temperature.

7. The method claim 6, further comprising:

increasing, via the NTC thermistor, the gate resistance based on a reduced current load associated with the gate drive voltage, and/or
increasing, via the NTC thermistor, the gate resistance based on a reduction in the sensed junction temperature.

8. The method of any of claims 6 to 7, wherein the gate resistor is associated with:

a minimum gate resistance corresponding to the radiated emissions limit; and
a maximum gate resistance based on a power capacity of the semiconductor switch.

9. The method of any of claims 6 to 8, wherein the semiconductor switch is an insulated gate bipolar transistor "IGBT".

10. The gate drive circuit of any of claims 1 to 5 and the method of any of claims 6 to 9. wherein the at least one semiconductor switch and the gate resistance device includes at least one surface-mounted device "SMD".

11. The gate drive circuit of any of claims 1 to 5 and the method of any of claims 6 to 10, wherein the turn-on switching timing includes at least one of:

a turn-on delay associated with the on state;
a rise time associated with the on state;
or
a charging time associated with the on state,
and/or, wherein the turn-off switching timing includes at least one of:

a turn-off delay associated with the off state;
a fall time associated with the off state;
or
a discharging time associated with the off state.

**Patentansprüche**

1. Gate-Ansteuerschaltung (400), die Folgendes umfasst:
mindestens einen Halbleiterschalter (406, Q4), der konfiguriert ist, als Antwort auf ein Steuersignal, das von einem Steuerschalter (Q1, Q2) empfangen wird, Leistung zuzuführen, wobei der mindestens eine Halbleiterschalter (406, Q4) Folgendem zugeordnet ist:

einem Grenzwert für ausgestrahlte Emissionen; und
einer Übergangstemperatur;
wobei eine Gate-Ansteuerspannung des mindestens einen Halbleiterschalters (406, Q4) Folgendes ist:

entweder eine positive Spannung, die einem Ein-Zustand entspricht, wobei der Ein-Zustand einer Einschalt-Schaltzeitvorgabe und/oder einem Einschalt-Schaltverlust zugeordnet ist; oder
eine nicht positive Spannung, die einem Aus-Zustand entspricht, wobei der Aus-Zustand einer Ausschalt-Schaltzeitvorgabe und/oder einem Ausschalt-Schaltverlust zugeordnet ist; und
eine Gate-Widerstandsvorrichtung (408), die zwischen dem Steuerschalter (Q1, Q2) und dem mindestens einen Halbleiterschalter (406, Q4) in Reihe geschaltet ist, wobei die Gate-Widerstandsvorrichtung mit dem mindestens einen Halbleiterschalter (406, Q4) thermisch gekoppelt ist, wobei die Gate-Widerstandsvorrichtung einen Thermistor (410) mit negativem Temperaturkoeffizienten, "NTC"-Thermistor, und einen Gate-Widerstand (412), die parallel geschaltet sind, umfasst;
wobei der NTC-Thermistor (410) konfiguriert ist zum:

Erfassen einer Übergangstemperatur, die dem Ein-Zustand und/oder dem Aus-Zustand zugeordnet ist; und
als Antwort auf eine Änderung der Übergangstemperatur, Einstellen der zugeordneten Einschalt- oder Ausschalt-Schaltzeitvorgabe und/oder des zugeordneten Einschalt- oder Ausschalt-Schaltverlustes durch Einstellen eines Gate-Widerstands der Gate-Widerstandsvorrichtung,
**dadurch gekennzeichnet, dass**
der NTC-Thermistor konfiguriert ist, den Gate-Widerstand auf der Grundlage einer umgekehrten linearen Relation zu einer Zunahme der erfassten Übergangstemperatur zu verringern.

2. Gate-Ansteuerschaltung nach einem der vorhergehenden Ansprüche, wobei der NTC-Thermistor konfiguriert ist, den Gate-Widerstand auf der Grundlage einer verringerten Stromlast, die der Gate-Ansteuerspannung zugeordnet ist, zu erhöhen.

3. Gate-Ansteuerschaltung nach einem der vorhergehenden Ansprüche, wobei der NTC-Thermistor konfiguriert ist, den Gate-Widerstand auf der Grundlage einer Verringerung der erfassten Übergangstemperatur zu erhöhen.

4. Gate-Ansteuerschaltung nach einem der vorhergehenden Ansprüche, wobei der Gate-Widerstand Folgendem zugeordnet ist:

einem minimalen Gate-Widerstand, der dem Grenzwert für ausgestrahlte Emissionen entspricht; und
einem maximalen Gate-Widerstand auf der Grundlage einer Leistungskapazität des Halbleiterschalters.

5. Gate-Ansteuerschaltung nach einem der vorhergehenden Ansprüche, wobei der mindestens eine Halbleiterschalter mindestens einen bipolaren Transistor mit isoliertem Gate, "IGBT", enthält.

6. Verfahren zum optimalen Schalten eines Halbleiterschalters, wobei das Verfahren Folgendes umfasst:

In-Reihe-Schalten einer Gate-Widerstandsvorrichtung zwischen dem Halbleiterschalter und einem Steuerschalter des Halbleiterschalters,
wobei der Steuerschalter zum Zuführen einer Gate-Ansteuerspannung zum Halbleiterschalter konfiguriert ist, der Halbleiterschalter einem Grenzwert für ausgestrahlte Emissionen und einer Übergangstemperatur zugeordnet ist, die Gate-Ansteuerspannung einem Ein-Zustand und/oder einem Aus-Zustand entspricht, der Ein-Zustand einer Einschalt-Schaltzeitvorgabe und einem Einschalt-Schaltverlust zugeordnet ist und der Aus-Zustand einer Ausschalt-Schaltzeitvorgabe und einem Ausschalt-Schaltverlust zugeordnet ist; und
wobei die Gate-Widerstandsvorrichtung mit dem Halbleiterschalter thermisch gekoppelt ist und einen Thermistor mit negativem Temperaturkoeffizienten, "NTC"-Thermistor, und einen Gate-Widerstand, die parallel geschaltet sind, umfasst;
Erfassen einer Übergangstemperatur, die dem Ein-Zustand und/oder dem Aus-Zustand zugeordnet ist, über den NTC-Thermistor; und
als Antwort auf eine Änderung der Übergangstemperatur, Einstellen der zugeordneten Einschalt- oder Ausschalt-Schaltzeitvorgabe und/oder des zugeordneten Einschalt- oder Ausschalt-Schaltverlustes durch Einstellen eines Gate-Widerstands der Gate-Widerstandsvorrichtung über den NTC-Thermistor,
**dadurch gekennzeichnet, dass**
das Verringern eines Gate-Widerstands der Gate-Widerstandsvorrichtung über den NTC-Thermistor Folgendes enthält:
Verringern des Gate-Widerstands auf der Grundlage einer umgekehrten linearen Relation zu einer Zunahme der erfassten Übergangstemperatur.

7. Verfahren nach Anspruch 6, das ferner Folgendes umfasst:
Erhöhen des Gate-Widerstands auf der Grundlage einer verringerten Stromlast, die der Gate-Ansteuerspannung zugeordnet ist, über den NTC-Thermistor, und/oder Erhöhen des Gate-Widerstands auf der Grundlage einer Verringerung der erfassten Übergangstemperatur über den NTC-Thermistor.

8. Verfahren nach einem der Ansprüche 6 bis 7, wobei der Gate-Widerstand Folgendem zugeordnet ist:

   einem minimalen Gate-Widerstand, der dem Grenzwert für ausgestrahlte Emissionen entspricht; und
   einem maximalen Gate-Widerstand auf der Grundlage einer Leistungskapazität des Halbleiterschalters.

9. Verfahren nach einem der Ansprüche 6 bis 8, wobei der Halbleiterschalter ein bipolarer Transistor mit isoliertem Gate, "IGBT", ist.

10. Gate-Ansteuerschaltung nach einem der Ansprüche 1 bis 5 und Verfahren nach einem der Ansprüche 6 bis 9, wobei der mindestens eine Halbleiterschalter und die Gate-Widerstandsvorrichtung mindestens eine oberflächenbestückte Vorrichtung, "SMD"-Vorrichtung, enthalten.

11. Gate-Ansteuerschaltung nach einem der Ansprüche 1 bis 5 und Verfahren nach einem der Ansprüche 6 bis 10, wobei die Einschalt-Schaltzeitvorgabe Folgendes enthält:

   eine Einschaltverzögerung, die dem Ein-Zustand zugeordnet ist; und/oder
   eine Anstiegszeit, die dem Ein-Zustand zugeordnet ist; und/oder
   eine Ladezeit, die dem Ein-Zustand zugeordnet ist,
   und/oder wobei die Ausschalt-Schaltzeitvorgabe Folgendes enthält:

      eine Ausschaltverzögerung, die dem Aus-Zustand zugeordnet ist; und/oder
      eine Abfallzeit, die dem Aus-Zustand zugeordnet ist; und/oder
      und/oder
      eine Entladezeit, die dem Aus-Zustand zugeordnet ist.

**Revendications**

1. Circuit d'attaque de grille (400), comprenant :
   au moins un commutateur à semi-conducteur (406, Q4) configuré pour fournir de la puissance en réponse à un signal de commande reçu en provenance d'un commutateur de commande (Q1, Q2), l'au moins un commutateur à semi-conducteur (406, Q4) étant associé à :

   une limite d'émissions rayonnées ; et
   une température de jonction ;
   une tension d'attaque de grille de l'au moins un commutateur à semi-conducteur (406, Q4) étant une parmi :

      une tension positive correspondant à un état passant, l'état passant étant associé à au moins une parmi une synchronisation de commutation d'activation ou une perte de commutation d'activation ; et
      une tension non positive correspondant à un état bloqué, l'état bloqué étant associé à au moins une parmi une synchronisation de commutation de désactivation ou une perte de commutation de désactivation ; et
      un dispositif à résistance de grille (408) connecté en série entre le commutateur de commande (Q1, Q2) et l'au moins un commutateur à semi-conducteur (406, Q4), le dispositif à résistance de grille étant couplé thermiquement à l'au moins un commutateur à semi-conducteur (406, Q4), le dispositif à résistance de grille comprenant une thermistance à coefficient de température négatif « NTC » (410) et une résistance de grille (412) connectées en parallèle ;
      le dispositif NTC (410) étant configuré pour :

         détecter une température de jonction associée à au moins un parmi l'état passant ou l'état bloqué ; et
         en réponse à un changement de la température de jonction, ajuster une ou plusieurs parmi la synchronisation de commutation d'activation ou de désactivation associée ou la perte de commutation d'activation ou de désactivation associée en ajustant une résistance de grille du dispositif à résistance de grille,
         **caractérisé en ce que**
         la thermistance NTC est configurée pour réduire la résistance de grille sur la base d'une relation linéaire inverse avec une augmentation de la température de jonction détectée.

**2.** Circuit d'attaque de grille selon l'une quelconque des revendications précédentes, la thermistance NTC étant configurée pour augmenter la résistance de grille sur la base d'une charge de courant réduite associée à la tension d'attaque de grille.

**3.** Circuit d'attaque de grille selon l'une quelconque des revendications précédentes, la thermistance NTC étant configurée pour augmenter la résistance de grille sur la base d'une réduction de la température de jonction détectée.

**4.** Circuit d'attaque de grille selon l'une quelconque des revendications précédentes, la résistance de grille étant associée à :

une résistance de grille minimale correspondant à la limite d'émissions rayonnées ; et
une résistance de grille maximale basée sur une capacité de puissance du commutateur à semi-conducteur.

**5.** Circuit d'attaque de grille selon l'une quelconque des revendications précédentes, l'au moins un commutateur à semi-conducteur comportant au moins un transistor bipolaire à grille isolée « IGBT ».

**6.** Procédé de commutation optimale d'un commutateur à semi-conducteur, le procédé comprenant :

la connexion en série d'un dispositif à résistance de grille entre le commutateur à semi-conducteur et un commutateur de commande du commutateur à semi-conducteur, le commutateur de commande étant configuré pour fournir une tension d'attaque de grille au commutateur à semi-conducteur, le commutateur à semi-conducteur étant associé à une limite d'émissions rayonnées et à une température de jonction, la tension d'attaque de grille correspondant à au moins un parmi un état passant ou un état bloqué, l'état passant étant associé à une synchronisation de commutation d'activation et une perte de commutation d'activation, l'état bloqué étant associé à une synchronisation de commutation de désactivation et une perte de commutation de désactivation ; et
le dispositif à résistance de grille étant couplé thermiquement au commutateur à semi-conducteur et comprenant une thermistance à coefficient de température négatif « NTC » et une résistance de grille connectées en parallèle ;
la détection, via la thermistance NTC, d'une température de jonction associée à au moins un parmi l'état passant ou l'état bloqué ; et
en réponse à une modification de la température de jonction, l'ajustement d'une ou plusieurs parmi la synchronisation de commutation d'activation ou de désactivation associée ou la perte de commutation d'activation ou de désactivation associée en ajustant, via la thermistance NTC, une résistance de grille du dispositif de résistance de grille,
**caractérisé en ce que**
la réduction, via la thermistance NTC, d'une résistance de grille du dispositif à résistance de grille, comporte :
la réduction de la résistance de grille sur la base d'une relation linéaire inverse avec une augmentation de la température de jonction détectée.

**7.** Procédé de la revendication 6, comprenant en outre : l'augmentation, via la thermistance NTC, de la résistance de grille sur la base d'une charge de courant réduite associée à la tension d'attaque de grille, et/ou l'augmentation, via la thermistance NTC, de la résistance de grille sur la base d'une réduction de la température de jonction détectée.

**8.** Procédé selon l'une quelconque des revendications 6 à 7, la résistance de grille étant associée à :

une résistance de grille minimale correspondant à la limite d'émissions rayonnées ; et
une résistance de grille maximale basée sur une capacité de puissance du commutateur à semi-conducteur.

**9.** Procédé selon l'une quelconque des revendications 6 à 8, le commutateur à semi-conducteur étant un transistor bipolaire à grille isolée « IGBT ».

**10.** Circuit d'attaque de grille selon l'une quelconque des revendications 1 à 5 et procédé selon l'une quelconque des revendications 6 à 9, l'au moins un commutateur à semi-conducteur et le dispositif à résistance de grille comportant au moins un dispositif de montage en surface « SMD ».

**11.** Circuit d'attaque de grille selon l'une quelconque des revendications 1 à 5 et procédé selon l'une quelconque des revendications 6 à 10, la synchronisation de commutation d'activation comportant au moins une parmi :

une temporisation d'activation associée à l'état passant ;
un temps de montée associé à l'état passant ;
ou
un temps de charge associé à l'état passant,
et/ou, la synchronisation de commutation de désactivation comportant au moins un parmi :

une temporisation de désactivation associée à l'état bloqué ;
un temps de descente associé à l'état bloqué ;
ou
un temps de décharge associé à l'état bloqué.

FIG. 1

FIG. 2B

FIG. 2A

15

| $t_{d(ON)}$ | Turn-on delay time, inductive load | $I_C = 50A$, $V_{CE} = 600$ V $V_{GE} = \pm 15$ V $R_{G(ON)} = 15\ \Omega$ | $T_j = 25°$ C $T_j = 125°$ C $T_j = 150°$ C | 0.16 μs 0.17 μs 0.17 μs |
|---|---|---|---|---|
| $t_r$ | Rise time, inductive load | $I_C = 50A$, $V_{CE} = 600$ V $V_{GE} = \pm 15$ V $R_{G(ON)} = 15\ \Omega$ | $T_j = 25°$ C $T_j = 125°$ C $T_j = 150°$ C | 0.03 μs 0.04 μs 0.04 μs |
| $t_{d(OFF)}$ | Turn-off delay time, inductive load | $I_C = 50A$, $V_{CE} = 600$ V $V_{GE} = \pm 15$ V $R_{G(ON)} = 15\ \Omega$ | $T_j = 25°$ C $T_j = 125°$ C $T_j = 150°$ C | 0.33 μs 0.43 μs 0.45 μs |
| $t_f$ | Fall time, inductive load | $I_C = 50A$, $V_{CE} = 600$ V $V_{GE} = \pm 15$ V $R_{G(ON)} = 15\ \Omega$ | $T_j = 25°$ C $T_j = 125°$ C $T_j = 150°$ C | 0.08 μs 0.15 μs 0.17 μs |
| $E_{on}$ | Turn-on energy loss, per pulse | $I_C = 50A$, $V_{CE} = 600$ V $V_{GE} = \pm 15$ V, di/dt = 1400 A/μs ($T_j = 150°$ C) $R_{G(ON)} = 15\ \Omega$ | $T_j = 25°$ C $T_j = 125°$ C $T_j = 150°$ C | 5.70 mJ 7.70 mJ 8.70 mJ |
| $E_{off}$ | Turn-off energy loss, per pulse | $I_C = 50A$, $V_{CE} = 600$ V $V_{GE} = \pm 15$ V, du/dt = 3600 V/μs ($T_j = 150°$ C) $R_{G(ON)} = 15\ \Omega$ | $T_j = 25°$ C $T_j = 125°$ C $T_j = 150°$ C | 2.80 mJ 4.30 mJ 4.80 mJ |

## FIG. 3

FIG. 4

**FIG. 5A**

**FIG. 5B**

25° C, Fixed Gate Resistor (Typical Timing)

125° C, Fixed Gate Resistor (Timing Increased)

125° C, NTC Gate Drive Resistor (Timing Reduced)

FIG. 6

700

702

Serially connecting a gate resistance device between a semiconductor switch of a semiconductor device and a control switch of the semiconductor device,

the semiconductor switch configured for supplying a gate drive voltage to the semiconductor device in response to a control signal received from the control switch,

the semiconductor switch associated with a radiated emissions limit and a junction temperature, the gate drive voltage corresponding to at least one of an on state or an off state, the on state associated with a turn-on switching timing and a turn-on switching loss, the off state associated with a turn-off switching timing and a turn-off switching loss

and

the gate resistance device thermally coupled to the semiconductor switch and comprising a negative temperature coefficient, NTC, thermistor and a linear gate resistor connected in parallel

704

Sensing, via the NTC thermistor, a junction temperature associated with at least one of the on state or the off state

706

When the junction temperature meets or exceeds a threshold level, reducing, via the NTC thermistor, a gate resistance of the linear gate resistor

## FIG. 7A

700

FIG. 7A

708 Increasing, via the NTC thermistor, the gate resistance based on a reduced current load associated with the gate drive voltage

**FIG. 7B**

700

FIG. 7A

710 Increasing, via the NTC thermistor, the gate resistance based on a reduction in the sensed junction temperature

**FIG. 7C**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202311043329
- US 2020021102 A1
- CN 107171659 A
- DE 102010043109 A1